# EUROPEAN PATENT APPLICATION

(11) **EP 4 527 553 A1**
(43) Date of publication of application: **26.03.2025**
(21) Application number: 23807562.6
(22) Date of filing: 12.05.2023
(51) Int. Cl.: B24B 37/005, B24B 37/013, B24B 37/30, B24B 41/06, B24B 47/22, B24B 49/12, H01L 21/304

(54) **SUBSTRATE POLISHING METHOD, PROGRAM, AND SUBSTRATE POLISHING DEVICE**

(30) Priority: 18.05.2022 JP 2022081873
(71) Applicant: EBARA CORPORATION, Ota-ku, Tokyo 144-8510 (JP)
(72) Inventor: SAITO, Ayumu, Tokyo 144-8510 (JP)
(74) Representative: Schmidbauer, Andreas Konrad
(86) International application number: PCT/JP2023/017893
(87) International publication number: WO 2023/223959

(57) **Abstract**

A substrate polishing method and the like for performing polishing in correspondence with substrates having various dimensions are provided. The substrate polishing method by a polishing apparatus is provided, the polishing apparatus including a polishing table having a polishing surface, a top ring for holding a substrate to press the substrate onto the polishing surface, and an upward/downward moving mechanism that moves the top ring up and down. The method includes an acquisition step of acquiring information on a thickness of the substrate, a position adjustment step of adjusting a height position of the top ring relative to the polishing table based on the acquired information on the thickness of the substrate, and a polishing step of supplying a pressure fluid to a pressure chamber of the top ring and pressing the substrate onto the polishing surface to polish the substrate.

## Description

### TECHNICAL FIELD

The present application relates to a substrate polishing method, a program, and a substrate polishing apparatus.

### BACKGROUND ART

In the manufacture of semiconductor devices, a chemical mechanical polishing (CMP) apparatus is used to planarize the surface of a substrate. The substrate for use in the manufacture of semiconductor devices is often disk-shaped. Not just a semiconductor device, requirements for flatness are increasing in planarizing the surface of a quadrangular substrate, such as a copper clad laminate substrate (CCL substrate), a printed circuit board (PCB) substrate, a photomask substrate, and a display panel. In addition, there is also an increasing demand for planarizing the surface of a package substrate on which electronic devices such as PCB substrates are arranged.

As a substrate holding device in a substrate polishing apparatus, a so-called floating type top ring is widely used, which has an elastic film (membrane) fixed to a chucking plate, and presses a semiconductor wafer onto a polishing pad with a fluid pressure via the elastic film by supplying a fluid such as air to a pressure chamber (pressurizing chamber) formed in an upper part of a chucking plate, and a pressure chamber formed from the elastic film (membrane). Furthermore, as the substrate holding device, a device including an upward/downward moving mechanism that moves a carrier (top ring body) supporting the membrane up and down is known. Polishing is performed to achieve a desired polishing profile, by adjusting a position of the top ring body relative to a polishing table with the upward/downward moving mechanism, and then adjusting a pressure in the membrane.

### CITATION LIST

### PATENT LITERATURE

PTL 1: Japanese Patent Laid-Open No. 2003-103458
PTL 2: Japanese Patent Laid-Open No. 2014-176950
PTL 3: Japanese Patent Laid-Open No. 2010-46756

### SUMMARY OF INVENTION

### TECHNICAL PROBLEM

In general, a semiconductor substrate has a determined dimension in accordance with standards (for example, SEMI Standards). However, the above-described substrates such as a CCL substrate, a PCB substrate, a photomask substrate, and a display panel often have no dimensional standards, and substrates with various dimensions may exist. When holding a substrate with such a substrate holding device as described above, a positional relation between the substrate and a polishing table varies if the dimension of the substrate is different. In particular, if a thickness of the substrate is different, a positional relation between a polishing surface of the polishing table and the surface to be polished of the substrate varies, and control of the substrate holding device, or a polishing profile may be adversely affected.

In view of the above circumstances, an object of the present application is to provide a substrate polishing method, program, or substrate polishing apparatus for performing polishing in correspondence with substrates having various dimensions.

### SOLUTION TO PROBLEM

According to an embodiment, a substrate polishing method by a polishing apparatus is provided, the polishing apparatus including a polishing table having a polishing surface, a top ring for holding a substrate to press the substrate onto the polishing surface, an upward/downward moving mechanism that moves the top ring up and down, and a sensor for acquiring information on a thickness of the substrate, the top ring including a membrane that is an elastic film and that forms a pressure chamber to which a pressure fluid is supplied, and a top ring body that holds the membrane, the top ring being configured to press the substrate onto the polishing surface by the pressure fluid being supplied to the pressure chamber, the substrate polishing method including an acquisition step of acquiring information on the thickness of the substrate by the sensor, a position adjustment step of adjusting a height position of the top ring relative to the polishing table based on the acquired information on the thickness of the substrate, and a polishing step of supplying the pressure fluid to the pressure chamber and pressing the substrate onto the polishing surface, to polish the substrate.

According to another embodiment, a program for causing a processing device of a polishing apparatus to perform a control process of performing a polishing process on a processing surface of a substrate is provided, the polishing apparatus including a polishing table having a polishing surface, a top ring for holding the substrate to press the substrate onto the polishing surface, an upward/downward moving mechanism that moves the top ring up and down, and a sensor for acquiring information on a thickness of the substrate, the top ring including a membrane that is an elastic film and that forms a pressure chamber to which a pressure fluid is supplied, and a top ring body that holds the membrane, the top ring being configured to press the substrate onto the polishing surface by the pressure fluid being supplied to the pressure chamber, the control process including an acquisition step of acquiring the information on the thickness of the substrate by the sensor, a position adjustment step of adjusting a height position of the top ring relative to the polishing table based on the acquired information on the thickness of the substrate, and a polishing step of supplying the pressure fluid to the pressure chamber and pressing the substrate onto the polishing surface, to polish the substrate.

According to still another embodiment, a substrate polishing apparatus is provided, the substrate polishing apparatus including: a polishing table having a polishing surface; a top ring for holding a substrate to press the substrate onto the polishing surface, the top ring including a membrane that is an elastic film and that forms a pressure chamber to which a pressure fluid is supplied, and a top ring body that holds the membrane, the top ring being configured to press the substrate onto the polishing surface by the pressure fluid being supplied to the pressure chamber; an upward/downward moving mechanism that moves the top ring up and down; a sensor for acquiring information on a thickness of the substrate; and a controller configured to adjust a height position of the top ring relative to the polishing table based on the information on the thickness of the substrate that is acquired by the sensor and supply the pressure fluid to the pressure chamber to press the substrate onto the polishing surface and thereby polish the substrate.

### BRIEF DESCRIPTION OF DRAWINGS

Fig. 1 is a plan view showing an overall configuration of a substrate polishing apparatus according to an embodiment.
Fig. 2 is a side view schematically showing a load unit according to an embodiment.
Fig. 3 is a perspective view showing a conveyer mechanism in the load unit according to an embodiment.
Fig. 4 is a side view schematically showing a conveyer unit according to an embodiment.
Fig. 5 is a perspective view showing a pusher according to an embodiment.
Fig. 6 is a partially cross-sectional view of the pusher shown in Fig. 5 as viewed in a direction of arrow 6.
Fig. 7 is a partially cross-sectional view showing that first and second stages are in an upper position.
Fig. 8 is a partially cross-sectional view showing that the first and second stages are in the upper position and that the second stage is at a raised position relative to the first stage.
Fig. 9 is a perspective view schematically showing a polishing unit according to an embodiment.
Fig. 10 is a cross-sectional view showing an example of a top ring constituting a polishing head that holds a substrate to press the substrate onto a polishing surface on a polishing table.
Fig. 11 is a flowchart showing a substrate polishing method according to an embodiment.
Fig. 12 is a cross-sectional view showing a top ring and a polishing pad when the substrate has a relatively small thickness, according to an embodiment.
Fig. 13 is a cross-sectional view showing a top ring and a polishing pad when the substrate has a relatively large thickness, according to an embodiment.

### DESCRIPTION OF EMBODIMENTS

Hereinafter, embodiments of the present invention will be described with reference to the drawings. In the drawings described below, the same or corresponding components are denoted with the same reference signs and duplicate descriptions are omitted.

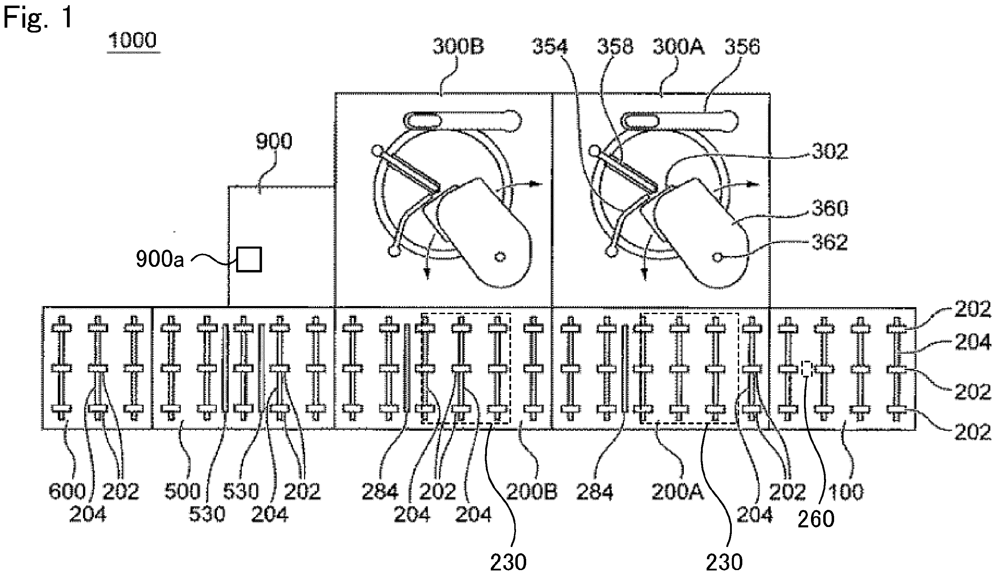

Fig. 1 is a plan view showing an overall configuration of a substrate polishing apparatus 1000 according to an embodiment. The substrate polishing apparatus 1000 shown in Fig. 1 includes a load unit 100, a conveyer unit 200, a polishing unit 300, a drying unit 500, and an unload unit 600. In the shown embodiment, the conveyer unit 200 includes two conveyer units 200A, 200B, and the polishing unit 300 includes two polishing units 300A, 300B. One or three or more conveyer units 200, and one or three or more polishing units 300 may be provided. In an embodiment, each of these units can be formed independently. Forming the units independently allows the substrate polishing apparatus 1000 including different configurations to be easily formed by arbitrarily combining the numbers of the respective units. Furthermore, the substrate polishing apparatus 1000 includes a controller 900, and each component of the substrate polishing apparatus 1000 is controlled by the controller 900. In an embodiment, the controller 900 may be composed of a general computer including an input/output device, a computing device, a storage device (storage medium) 900a, and others. The controller 900 functions as an operating entity of controlling the substrate polishing apparatus 1000. The controller 900 performs various types of processing by reading and executing a program stored in the storage device 900a or the like. A program recorded on a recording medium such as a DVD-ROM may be acquired, or a program may be acquired via a network.

### <Load Unit>

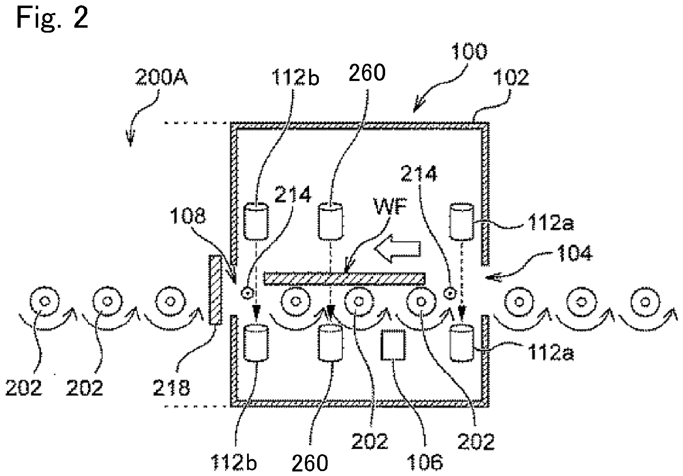

The load unit 100 is a unit for introducing, into the substrate polishing apparatus 1000, a substrate WF before polished, cleaned or otherwise treated. Fig. 2 is a side view schematically showing the load unit 100 according to an embodiment. In an embodiment, the load unit 100 includes a housing 102. The housing 102 includes an inlet opening 104 on a side to receive the substrate WF. In the embodiment shown in Fig. 2, the right side is an inlet side. The load unit 100 receives, from the inlet opening 104, the substrate WF to be processed. Upstream of the load unit 100 (on the right side in Fig. 2), a processing device is disposed in which a process step prior to processing of the substrate WF by the substrate polishing apparatus 1000 according to the present disclosure is performed. In the embodiment shown in Fig. 2, the load unit 100 includes an ID reader 106. The ID reader 106 reads the ID of the substrate received through the inlet opening 104. The substrate polishing apparatus 1000 performs various types of processing on the substrate WF depending on the read ID. In an embodiment, the ID reader 106 may not be provided. In an embodiment, the load unit 100 is configured to comply with Surface Mount Equipment Manufacturers Association (SMEMA) mechanical device interface standards (IPC-SMEMA-9851).

In the embodiment shown in Fig. 2, the load unit 100 includes a plurality of conveying rollers 202 for conveying the substrate WF. By rotating the conveying rollers 202, the substrate WF on the conveying rollers 202 can be conveyed in a predetermined direction (leftward in Fig. 2). In the shown embodiment, the housing 102 of the load unit 100 includes an outlet opening 108 of the substrate WF. The load unit 100 includes a sensor 112 for detecting presence or absence of the substrate WF at a predetermined position on the conveying rollers 202. The sensor 112 may be any type of sensor, for example, an optical sensor. In the embodiment shown in Fig. 2, two sensors 112 are provided in the housing 102, one being a sensor 112a provided in the vicinity of the inlet opening 104, the other being a sensor 112b provided in the vicinity of the outlet opening 108. In an embodiment, the operation of the load unit 100 can be controlled in response to the detection of the substrate WF by the sensors 112. For example, when the sensor 112a in the vicinity of the inlet opening 104 detects the presence of the substrate WF, the rotation of the conveying rollers 202 in the load unit 100 may be started, or a rotation speed of the conveying rollers 202 may be changed. Furthermore, upon detection of the presence of the substrate WF by the sensor 112b in the vicinity of the outlet opening 108, an inlet shutter 218 of the conveyer unit 200A, which is a subsequent unit, may be opened. In an embodiment, the load unit 100 includes a sensor 260 for detecting a thickness of the substrate WF conveyed by the conveying rollers 202. The sensor 260 may be any type of sensor, for example, an optical ranging sensor. Note that the sensor 260 is not limited to that provided in the load unit 100, and in place of or in addition to the sensor, a sensor may be provided in the conveyer unit 200 to detect the thickness of the substrate WF on the conveying rollers 202 of the conveyer unit 200.

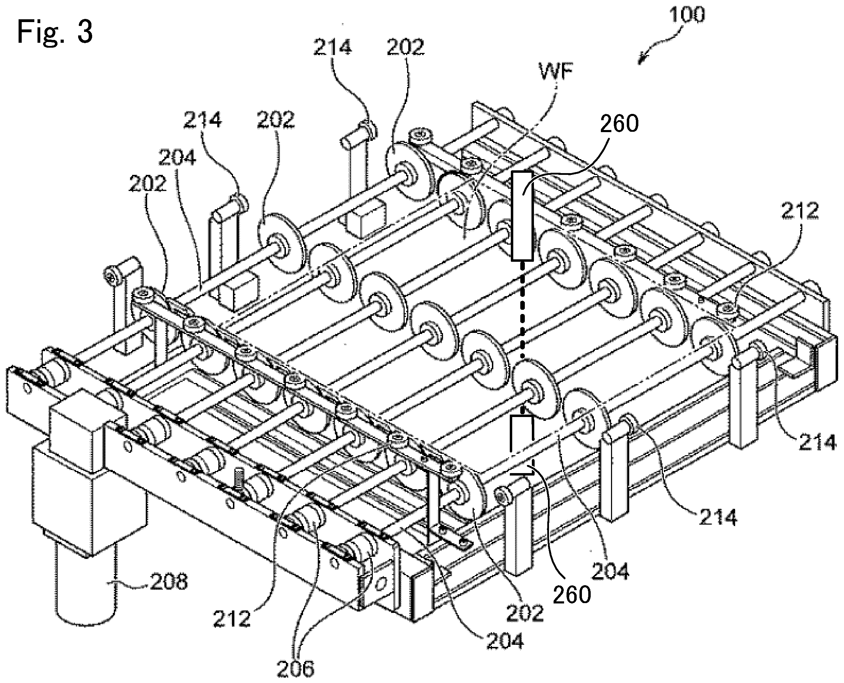

Fig. 3 is a perspective view showing a conveyer mechanism in the load unit 100 according to an embodiment. In the shown embodiment, the conveyer mechanism of the load unit 100 includes the plurality of conveying rollers 202 and a plurality of roller shafts 204 to which the conveying rollers 202 are attached. In the shown embodiment, three conveying rollers 202 are attached to the roller shafts 204, respectively. The substrate WF is disposed on the conveying rollers 202, and the substrate WF is conveyed by rotating the conveying rollers 202. Each conveying roller 202 may be attached at any position on the roller shaft 204 if the substrate WF can be stably conveyed to the position. However, the conveying roller 202 contacts the substrate WF, and the conveying roller 202 should be therefore disposed to contact a region where there is no problem even if the conveying roller contacts the substrate WF to be processed. In an embodiment, the conveying roller 202 of the load unit 100 may be made of a conductive polymer. In an embodiment, the conveying roller 202 is electrically grounded via the roller shaft 204 or the like. This is to prevent the substrate WF from being charged and the substrate WF from being damaged. Furthermore, in an embodiment, an ionizer (not shown) may be provided in the load unit 100 to prevent the substrate WF from being charged. In an embodiment, the sensor 260 for detecting the thickness of the substrate WF is disposed to detect a center (center in a direction perpendicular to a conveying direction) or the vicinity of the center of the substrate WF conveyed by the conveying rollers 202. Note that the sensor 260 is not limited to a sensor for detecting the center of the substrate WF, and the sensor may detect any location. Furthermore, for the sensor 260, as an example, a plurality of sensors may be provided to detect a plurality of locations in the direction perpendicular to the conveying direction, or a drive mechanism may be provided to move the sensor in the direction perpendicular to the conveying direction.

In the embodiment shown in Fig. 3, the roller shaft 204 is rotationally driven by a motor 208 via gears 206. In an embodiment, the motor 208 may be a servo motor. Use of the servo motor can control a rotation speed of the roller shafts 204 and conveying rollers 202, that is, a conveying speed of the substrate WF. In an embodiment, the gears 206 may be magnet gears. Each magnet gear is a non-contact power transmission mechanism, so that fine particles due to wear are not generated as in contact gears, and maintenance such as lubrication is not required any longer.

As shown in Figs. 2 and 3, the load unit 100 includes auxiliary rollers 214 in the vicinities of the inlet opening 104 and the outlet opening 108. Each auxiliary roller 214 is disposed about as high as the conveying roller 202. A position of the auxiliary roller 214 can be changed depending on a dimension of the substrate WF to be conveyed. The auxiliary rollers 214 support the substrate WF so that the substrate WF being conveyed does not fall between the unit and the other unit. The auxiliary rollers 214 are not connected to a power source and are freely rotatably configured.

In an embodiment, the load unit 100 may include a reversing machine (not shown) for reversing the received substrate WF. As an example, when the substrate WF is conveyed to the load unit 100 so that the surface of the substrate on which a pattern region is formed is an upper surface according to specifications of an upstream processing device, the substrate WF is reversed by the reversing machine so that the surface of the substrate WF on which the pattern region is formed is a lower surface, and subsequent processing of the substrate polishing apparatus 1000 may be then performed.

### <Conveyer unit>

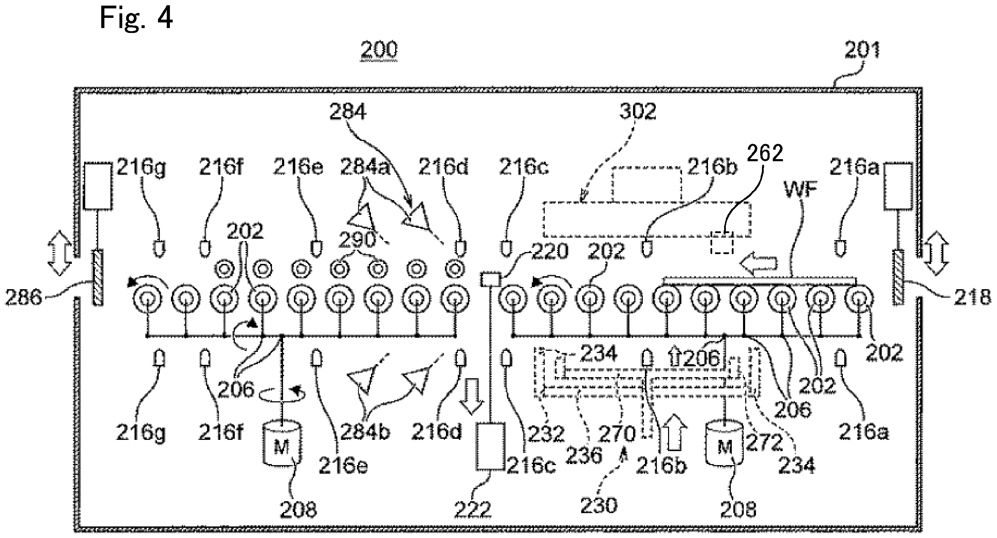

Fig. 4 is a side view schematically showing the conveyer unit 200 according to an embodiment. The substrate polishing apparatus 1000 shown in Fig. 1 includes two conveyer units 200A and 200B. The two conveyer units 200A and 200B can include the same configuration and will be therefore collectively described as the conveyer unit 200 below. The conveyer unit 200 includes a plurality of conveying rollers 202 for conveying the substrate WF. By rotating the conveying rollers 202, the substrate WF on the conveying rollers 202 can be conveyed in the predetermined direction. The conveying rollers 202 of the conveyer unit 200 may be formed from a conductive polymer or a nonconductive polymer. Each of the conveying rollers 202 is attached to the roller shaft 204 (not shown in Fig. 4) in the same manner as in the conveyer mechanism of the load unit 100 described above and is driven by the motor 208 via the gears 206. In an embodiment, the motor 208 may be a servo motor, and each gear 206 may be a gear wheel and may be a magnet gear in the same manner as in the load unit 100. Furthermore, the shown conveyer unit 200 includes a guide roller 212 (not shown in Fig. 4) that supports the side surface of the substrate WF being conveyed in the same manner as in the load unit 100. The shown conveyer unit 200 includes a sensor 216 for detecting the presence or absence of the substrate WF at the predetermined position on the conveying rollers 202. The sensor 216 may be any type of sensor, for example, an optical sensor. In the embodiment shown in Fig. 4, seven sensors 216 (216a to 216g) are provided in the conveyer unit 200. In an embodiment, an operation of the conveyer unit 200 can be controlled in response to the detection of the substrate WF by these sensors 216a to 216g. However, the number and arrangement of the sensors 216 are not limited to the example shown in Fig. 4. The conveyer unit 200 includes an inlet shutter 218 that is openable and closeable to receive the substrate WF within the conveyer unit 200. For an embodiment, in the same manner as in the load unit 100, the conveyer unit 200 includes a support member (not shown in Fig. 4) disposed to prevent the substrate WF from slipping into a gap between the conveying rollers 202 adjacent in the conveying direction (not shown in Fig. 4), and a plurality of guide rollers 212 (not shown in Fig. 4) arranged to support the substrate WF on opposite sides of the substrate WF to be conveyed, in a width direction.

As shown in Fig. 4, the conveyer unit 200 includes a stopper 220. The stopper 220 is connected to a stopper moving mechanism 222, and the stopper 220 can enter a conveying path of the substrate WF moving on the conveying rollers 202. When the stopper 220 is in the conveying path of the substrate WF, a side surface of the substrate WF moving on the conveying rollers 202 contacts the stopper 220, and the moving substrate WF can be stopped at the position of the stopper 220. Furthermore, when the stopper 220 is at a position retracted from the conveying path of the substrate WF, the substrate WF can move on the conveying rollers 202. The stop position of the substrate WF by the stopper 220 is a position in which a pusher 230 described later can receive the substrate WF on the conveying rollers 202 (substrate transfer position).

As shown with a dashed line in Fig. 4, the conveyer unit 200 includes the pusher 230. The pusher 230 is configured to be able to lift the substrate WF on the plurality of conveying rollers 202 away from the plurality of conveying rollers 202. Furthermore, the pusher 230 is configured to be able to transfer the held substrate WF to and from the conveying roller 202 of the conveyer unit 200.

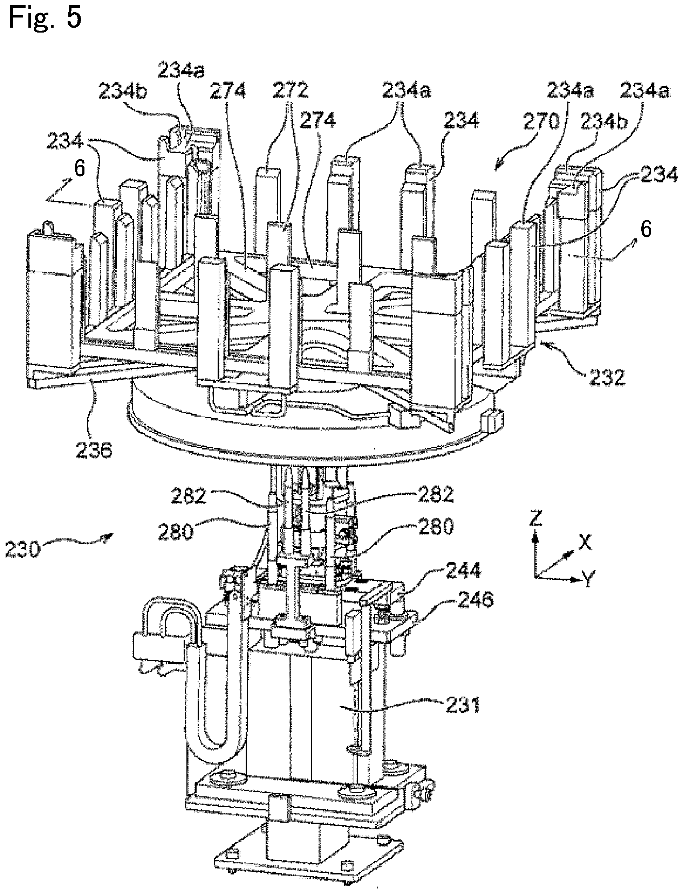

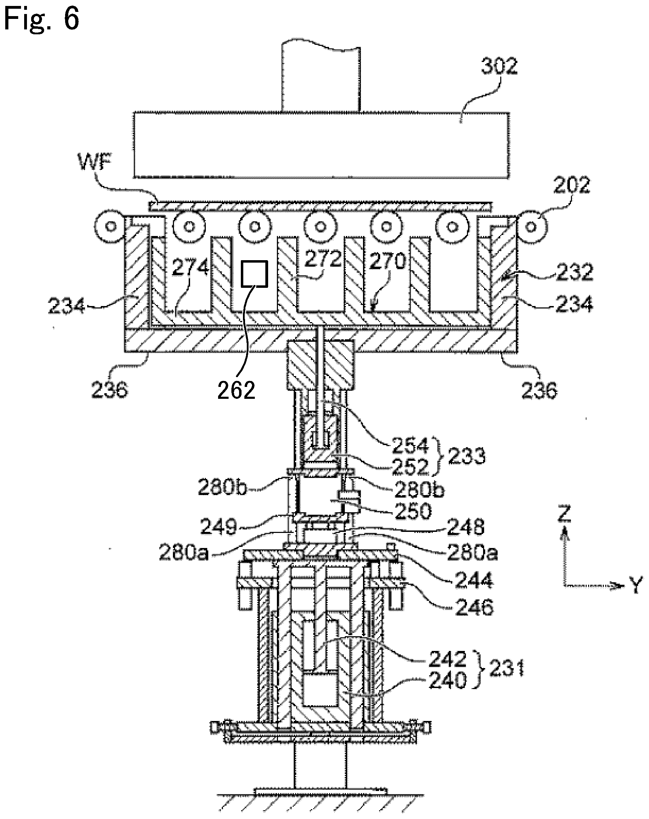

Fig. 5 is a perspective view showing the pusher 230 according to an embodiment. Fig. 6 is a partially cross-sectional view of the pusher 230 shown in Fig. 5 as viewed in a direction of arrow 6. Fig 6 schematically shows, together with the pusher 230, the conveying rollers 202, the substrate WF disposed at the substrate transfer position on the conveying rollers 202, and a top ring 302 that receives the substrate WF. In the embodiment shown in Figs. 5 and 6, the pusher 230 includes a first stage 232 and a second stage 270. The first stage 232 is a stage for supporting a retainer member 3 of the top ring 302 when the substrate WF is transferred from the pusher 230 to the top ring 302 described later. The first stage 232 includes a plurality of support posts 234. As shown in Fig. 5, each support post 234 has an end including a flat support surface 234a that supports the retainer member 3 of the top ring 302 and an inclined surface 234b for guiding the top ring 302. In an embodiment, support posts 234 at four corners among the plurality of support posts 234 may include the support surface 234a and the inclined surface 234b. The retainer member 3 can be aligned in a recess formed by the support posts 234 at the four corners. The support posts 234 other than those at the four corners may only include the support surface 234a. The other end of each support post 234 is coupled to a common base 236. Furthermore, each support post 234 is provided at a position that does not interfere with the conveying roller 202, and in the embodiment shown in Fig. 5, each support post 234 is disposed between the conveying rollers 202. The second stage 270 is configured to receive the substrate WF on the conveying rollers 202. The second stage 270 includes a plurality of support posts 272. Each support post 272 has one end including a flat support surface that supports the substrate WF. The other end of each support post 272 is coupled to a common base 274. Furthermore, each support post 272 is provided at a position that does not interfere with the conveying roller 202, and in the embodiment shown in Fig. 6, each support post 272 is disposed between the conveying rollers 202. The first stage 232 and the second stage 270 are each coupled to a lifting mechanism and movable in a height direction (z-direction) as described in detail below.

The first stage 232 is configured to be movable in the height direction (z-direction). In an embodiment, the pusher 230 includes a first lifting mechanism 231. In an embodiment, as shown in Figs. 5 and 6, the first lifting mechanism 231 of the pusher 230 is a pneumatic lifting mechanism and includes a cylinder 240 and a piston 242. The piston 242 has an end coupled to a movable pedestal 244. The cylinder 240 is coupled to a fixed pedestal 246. The fixed pedestal 246 is fixed to a housing 201 covering the whole conveyer unit 200 or a floor surface on which the conveyer unit 200 is installed. By adjusting an air pressure in the cylinder 240, the piston 242 can be moved to move the movable pedestal 244 in the height direction (z-direction). The movable pedestal 244 moving in the height direction can move the first stage 232 and the second stage 270 in the height direction. In the shown embodiment, on the movable pedestal 244, an XY stage 248 capable of moving the first stage 232 and the second stage 270 in a horizontal plane is mounted. The XY stage 248 may be a known XY stage configured to be movable in two orthogonal directions by a linear motion guide or the like. In the shown embodiment, a rotation stage 250 is mounted on top of the XY stage 248. The rotation stage 250 is configured to be rotatable in an XY plane (horizontal plane). In other words, the rotation stage 250 is configured to be rotatable about a z-axis. The rotation stage 250 can adopt a known rotation stage 250 composed of a rotating bearing or the like. A second lifting mechanism 233 is mounted above the rotation stage 250. The second lifting mechanism 233 includes a cylinder 252 and a piston 254. The cylinder 252 is coupled to the base 236 of the first stage 232. Furthermore, the movable piston 254 is coupled to the cylinder 252, and the piston 254 can be moved by adjusting the air pressure in the cylinder 252. The piston 254 has an end to which the base 274 of the second stage 270 is coupled. Therefore, by adjusting the air pressure in the cylinder 252, the piston 254 and the second stage 270 can be moved in the height direction (z-direction). Furthermore, according to the configuration described above, the first lifting mechanism 231 moves both the first stage 232 and the second stage 270 in the height direction (z-direction), and the second lifting mechanism 233 can move the second stage 270 in the height direction (z-direction) relative to the first stage 232. The first stage 232 and the second stage 270 are movable in two orthogonal directions (xy-direction) in the horizontal plane by the XY stage 248. Furthermore, the first stage 232 and the second stage 270 are rotatable in the horizontal plane (about the z-axis) by the rotation stage 250. Therefore, when the substrate WF is exchanged between the pusher 230 and the top ring 302 described later, alignment between the pusher 230 and the top ring 302 can be performed. In the shown embodiment, the first lifting mechanism 231 and second lifting mechanism 233 are pneumatic lifting mechanisms, but these lifting mechanisms may be hydraulic, or may be electric lifting mechanisms using a motor, ball screw, and the like.

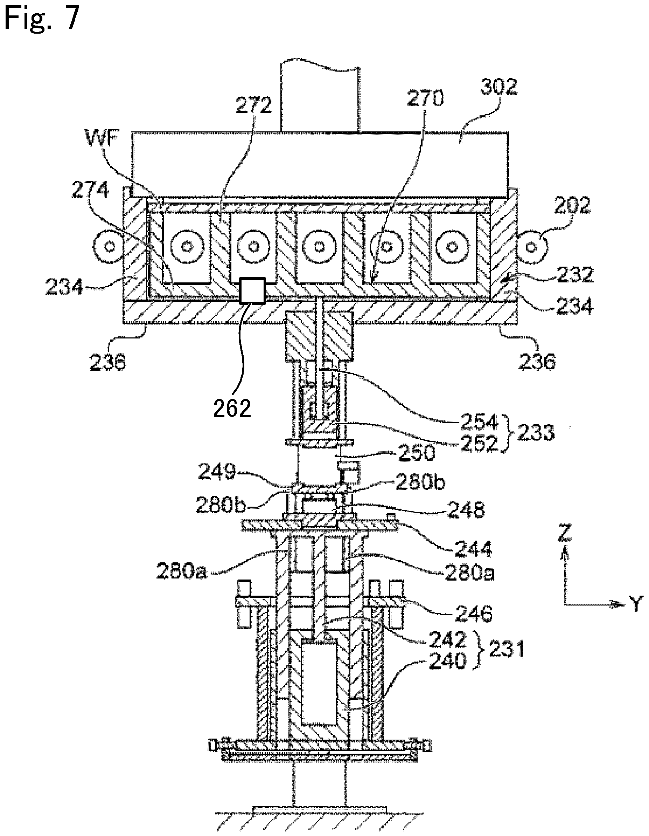

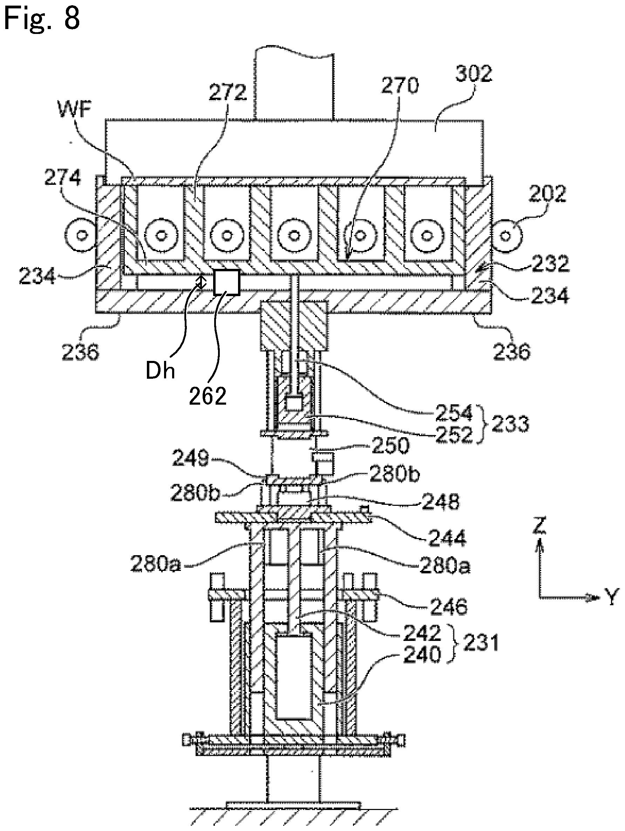

The first lifting mechanism 231 allows the first stage 232 and the second stage 270 to move between a lower position and an upper position. Fig. 6 shows that the first stage 232 and the second stage 270 are in the lower position. When the first stage 232 and the second stage 270 are in the lower position, the end of the support post 234 of the first stage 232 and the end of the support post 272 of the second stage 270 are lower than the surface of the conveying roller 202 that supports the substrate WF as shown in Fig. 6. Fig. 7 shows that the first stage 232 and the second stage 270 are in the upper position. When the first stage 232 and the second stage 270 are in the upper position, the end of the support post 234 of the first stage 232 and the end of the support post 272 of the second stage 270 are higher than the surface of the conveying roller 202 that supports the substrate. That is, when the first stage 232 and the second stage 270 move from the lower position to the upper position, the substrate WF disposed on the conveying rollers 202 can be lifted and received by the second stage 270. Fig. 8 shows that the first stage 232 and the second stage 270 are in the upper position and that the second stage 270 is in a raised position relative to the first stage 232. When the substrate WF is transferred from the pusher 230 to the top ring 302 described later, the second stage 270 holding the substrate WF is raised relative to the first stage 232 as shown in Fig. 8.

In an embodiment, the conveyer unit 200 includes a sensor 262 for detecting the thickness of the substrate WF transferred from the pusher 230 to the top ring 302 (see FIGS. 4 and 6 to 8). The sensor 262 may be any type of sensor and may adopt, for example, an optical ranging sensor. Information acquired by the sensor 262 is sent to the controller 900. In the example shown in Figs. 6 to 8, the sensor 262 is an image sensor attached to the housing 201, and a photographing direction is oriented horizontally. Based on imaging data acquired by the sensor 262, the controller 900 calculates an amount of movement Dh of the second stage 270 holding the substrate WF to the first stage 232 when the substrate WF is transferred from the pusher 230 to the top ring 302. The controller 900 is then configured to detect the thickness of the substrate WF based on the calculated amount of movement Dh. Note that the sensor 262 is not limited to such an example and can adopt a variety of known sensors such as a laser sensor, a potentiometer, an overcurrent sensor, an acceleration sensor, and a linear scale sensor for detecting the amount of movement Dh of the second stage 270 relative to the first stage 232. The sensor 262 may be mounted on the pusher 230 instead of or in addition to being attached to the housing 201. Furthermore, a plurality of sensors 262 may be provided.

The conveyer unit 200 shown in Fig. 4 includes a cleaner. As shown in Fig. 4, the cleaner includes a cleaning nozzle 284. The cleaning nozzle 284 includes an upper cleaning nozzle 284a disposed above the conveying roller 202 and a lower cleaning nozzle 284b disposed below. The upper cleaning nozzle 284a and the lower cleaning nozzle 284b are connected to a supply source (not shown) of a cleaning solution. The upper cleaning nozzle 284a is configured to supply the cleaning solution to an upper surface of the substrate WF conveyed on the conveying rollers 202. The lower cleaning nozzle 284b is configured to supply the cleaning solution to a lower surface of the substrate WF conveyed on the conveying rollers 202. The upper cleaning nozzle 284a and the lower cleaning nozzle 284b have a width equal to or greater than a width of the substrate WF conveyed on the conveying rollers 202 and are configured to clean the whole surface of the substrate WF when the substrate WF is conveyed on the conveying rollers 202. As shown in Fig. 4, the cleaner is located downstream of a substrate transfer location of the pusher 230 of the conveyer unit 200.

As shown in Fig. 4, in the cleaner, a pressure roller 290 is disposed above each conveying roller 202. Furthermore, the sensor 216d is disposed in the vicinity of an inlet of the cleaner. In an embodiment, once the substrate WF is detected by the sensor 216d, cleaning of the substrate WF can be started with the cleaning solution injected from the cleaning nozzle 284. Furthermore, during the cleaning of the substrate WF, the number of revolutions of the conveying roller 202 may be set to a speed for cleaning. In the embodiment of Fig. 4, the sensor 216f is disposed in the vicinity of a cleaner outlet point.
In an embodiment, once the substrate WF is detected by the sensor 216f, the injection of the cleaning solution from the cleaning nozzle 284 can be ended. During the cleaning of the substrate WF, the substrate WF is sandwiched and conveyed between the conveying rollers 202 and the pressure rollers 290, so that the substrate WF can be stably conveyed even during the injection of the cleaning solution.

As shown in Fig. 4, the conveyer unit 200 includes an outlet shutter 286 that is openable and closeable. Furthermore, the conveyer unit 200 includes the sensor 216g in the vicinity of an outlet. In an embodiment, once the substrate WF is detected by the sensor 216g, the outlet shutter 286 may be opened to convey the substrate WF to the next unit. In an embodiment, once the substrate WF is detected by the sensor 216g, the conveyance of the substrate WF on the conveying rollers 202 is stopped without opening the outlet shutter 286, to wait for a process of the next unit. Then, after the next unit is prepared for receiving the substrate, the outlet shutter 286 may be opened to convey the substrate WF to the next unit.

### <Polishing Unit>

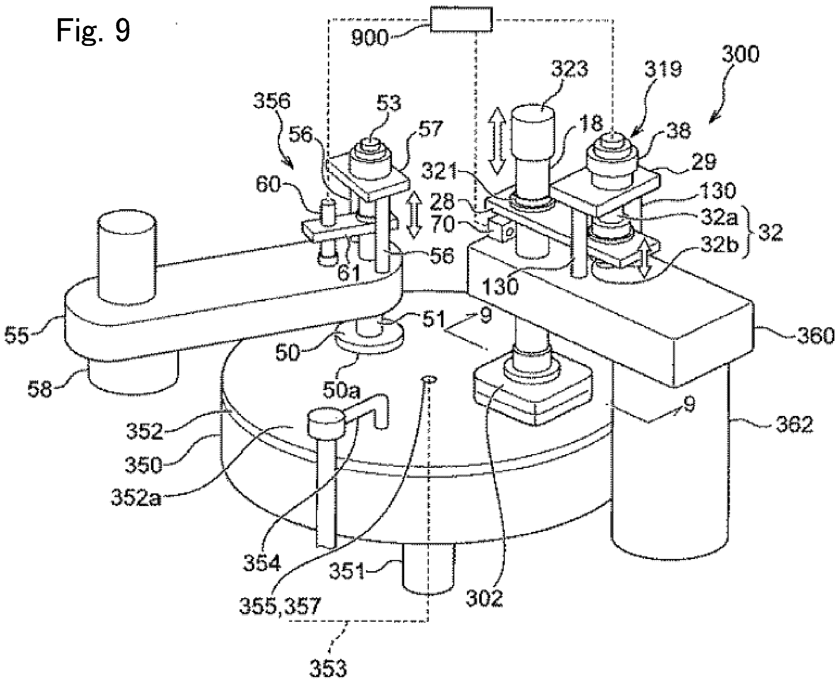

Fig. 9 is a perspective view schematically showing the polishing unit 300 according to an embodiment. The substrate polishing apparatus 1000 shown in Fig. 1 includes two polishing units 300A and 300B. The two polishing units 300A and 300B can include the same configuration and will be therefore collectively described as the polishing unit 300 below.

As shown in Fig. 9, the polishing unit 300 includes a polishing table 350, and the top ring 302 constituting a polishing head that holds a substrate to be polished and presses the substrate onto a polishing surface on the polishing table 350. The polishing table 350 is coupled to a polishing table rotation motor (not shown) disposed via and below a table shaft 351 and is rotatable about the table shaft 351. A polishing pad 352 is bonded to an upper surface of the polishing table 350, and a surface 352a of the polishing pad 352 constitutes the polishing surface to polish the substrate.

A polishing liquid supply nozzle 354 is installed above the polishing table 350, and the polishing liquid supply nozzle 354 supplies a polishing liquid onto the polishing pad 352 on the polishing table 350. Furthermore, as shown in Fig. 9, the polishing table 350 and the table shaft 351 are provided with a passage 353 for supplying the polishing liquid. The passage 353 communicates with an opening 355 on the surface of the polishing table 350. At a position corresponding to the opening 355 of the polishing table 350, a through hole 357 is formed in the polishing pad 352, and the polishing liquid through the passage 353 is supplied to the surface of the polishing pad 352 from the opening 355 of the polishing table 350 and the through hole 357 of the polishing pad 352. Note that one or more openings 355 of the polishing table 350 and one or more through holes 357 of the polishing pad 352 may or may not be provided.

The top ring 302 is connected to a top ring shaft 18, and the top ring shaft 18 is moved up and down relative to a swingable arm 360 by an upward/downward moving mechanism 319. Upward/downward movement of the top ring shaft 18 moves the whole top ring 302 up and down relative to the swingable arm 360 to position the top ring. The top ring shaft 18 is rotationally driven by a top ring rotation motor (not shown). The rotation of the top ring shaft 18 causes the top ring 302 to rotate about the top ring shaft 18. A rotary joint 323 is attached to an upper end of the top ring shaft 18.

The top ring 302 can hold the substrate on a lower surface thereof. The swingable arm 360 is configured to be pivotable about a spindle 362. Pivoting of the swingable arm 360 allows the top ring 302 to move between the substrate transfer position of the conveyer unit 200 described above and a position above the polishing table 350. By lowering the top ring shaft 18, the top ring 302 can be lowered to press the substrate onto the surface (polishing surface) 352a of the polishing pad 352. At this time, the top ring 302 and the polishing table 350 are each rotated, and the polishing liquid is supplied onto the polishing pad 352 from the polishing liquid supply nozzle 354 provided above the polishing table 350 and/or from the opening 355 provided in the polishing table 350. Thus, the surface of the substrate can be polished by pressing the substrate onto the polishing surface 352a of the polishing pad 352.

The upward/downward moving mechanism 319 that moves the top ring shaft 18 and the top ring 302 up and down includes a bridge 28 that rotatably supports the top ring shaft 18 via a bearing 321, a ball screw 32 attached to the bridge 28, a support base 29 supported by a post 130, and an AC servo motor 38 provided on the support base 29. The support base 29 supporting the servo motor 38 is fixed to the swingable arm 360 via the post 130.

The ball screw 32 includes a screw shaft 32a coupled to the servo motor 38, and a nut 32b with which the screw shaft 32a is screwed. The top ring shaft 18 moves up and down integrally with the bridge 28. Therefore, when the servo motor 38 is driven, the bridge 28 moves up and down via the ball screw 32, which causes the top ring shaft 18 and the top ring 302 to move up and down. The polishing unit 300 includes a ranging sensor 70 as a position detector that detects a distance to a lower surface of the bridge 28, that is, a position of the bridge 28. By detecting the position of the bridge 28 with the ranging sensor 70, a position of the top ring 302 can be detected. The ranging sensor 70 constitutes the upward/downward moving mechanism 319, together with the ball screw 32 and the servo motor 38. Note that the ranging sensor 70 may be a laser sensor, an ultrasonic sensor, an overcurrent sensor, or a linear scale sensor. Furthermore, equipment in the polishing unit, including the ranging sensor 70 and the servo motor 38, is configured to be controlled by the controller 900.

The polishing unit 300 according to an embodiment includes a dressing unit 356 that dresses the polishing surface 352a of the polishing pad 352. The dressing unit 356 includes a dresser 50 that slidably contacts the polishing surface 352a, a dresser shaft 51 to which the dresser 50 is coupled, an air cylinder 53 provided at an upper end of the dresser shaft 51, and a swingable arm 55 that rotatably supports the dresser shaft 51. The dresser 50 has a lower part composed of a dressing member 50a, and needle-shaped diamond particles adhere on a lower surface of the dressing member 50a. The air cylinder 53 is disposed on a support base 57 supported by posts 56, and the posts 56 are fixed to the swingable arm 55.

The swingable arm 55 is driven by a motor (not shown) and is configured to pivot about a spindle 58. The dresser shaft 51 is driven by a motor (not shown) to rotate, and the rotation of the dresser shaft 51 causes the dresser 50 to rotate about the dresser shaft 51.
The air cylinder 53 moves the dresser 50 up and down via the dresser shaft 51 and presses the dresser 50 onto the polishing surface 352a of the polishing pad 352 with a predetermined pressing force.

The dressing of the polishing surface 352a of the polishing pad 352 is performed as follows. The dresser 50 is pressed onto the polishing surface 352a by the air cylinder 53, and at the same time, pure water is supplied to the polishing surface 352a from a pure water supply nozzle (not shown). In this state, the dresser 50 is rotated about the dresser shaft 51, and the swingable arm 55 is swung on the polishing surface 352a, so that the lower surface (diamond particles) of the dressing member 50a is slidably in contact with the rotating polishing surface 352a. Thus, the polishing pad 352 is scraped off by the dresser 50 and the polishing surface 352a is dressed.

In the polishing apparatus of the present embodiment, the dresser 50 is used to measure an amount of wear on the polishing pad 352. That is, the dressing unit 356 includes a displacement sensor 60 that measures displacement of the dresser 50. The displacement sensor 60 constitutes wear amount detection means for detecting the amount of wear on the polishing pad 352 and is provided on an upper surface of the swingable arm 55. A target plate 61 is fixed to the dresser shaft 51, and the target plate 61 moves up and down with the upward/downward movement of the dresser 50. The displacement sensor 60 is disposed to be inserted through the target plate 61 and measures displacement of the target plate 61 to measure the displacement of the dresser 50. As the displacement sensor 60, any type of sensor such as a linear scale, a laser sensor, an ultrasonic sensor, or an eddy current sensor is used.

In the present embodiment, the amount of wear on the polishing pad 352 is measured as follows. First, the air cylinder 53 is driven to cause the dresser 50 to abut on the polishing surface 352a of the polishing pad 352 that has been initially dressed. In this state, the displacement sensor 60 detects an initial position (height initial value) of the dresser 50 and stores the initial position (height initial value) in the controller 900. Then, when a polishing process of one or more substrates is ended, the dresser 50 is again brought to abut on the polishing surface 352a, and the position of the dresser 50 is measured in this state. The position of the dresser 50 is displaced downward depending on the amount of wear on the polishing pad 352, so that the controller 900 can obtain the amount of wear on the polishing pad 352 by obtaining a difference between the initial position and a position of the dresser 50 after polishing. In this way, the amount of wear on the polishing pad 352 is obtained based on the position of the dresser 50.

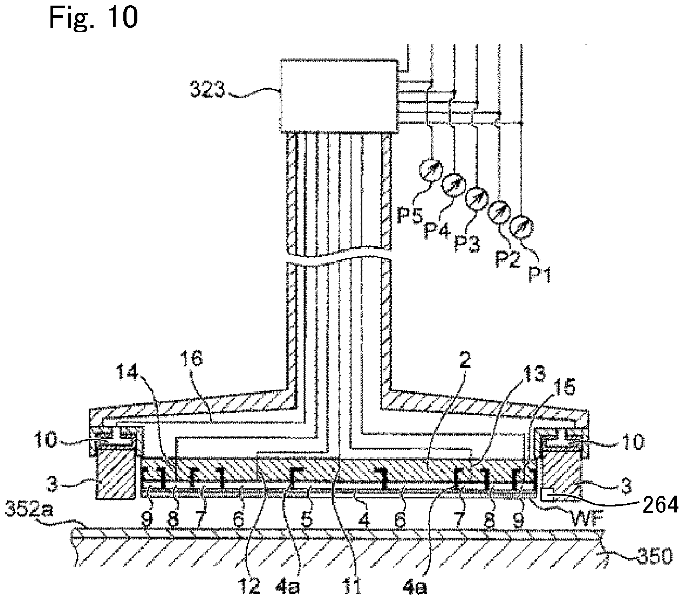

Next, the top ring 302 in the polishing unit 300 according to an embodiment will be described. Fig. 10 is a schematic cross-sectional view of the top ring 302 according to an embodiment, which holds the substrate to be polished, to press the substrate onto the polishing surface on the polishing pad. Fig. 10 only schematically shows main components constituting the top ring 302.

As shown in Fig. 10, the top ring 302 includes a top ring body 2 that presses the substrate WF onto the polishing surface 352a and the retainer member 3 that directly presses the polishing surface 352a. The top ring body 2 is made of a generally quadrangular flat plate member, and the retainer member 3 is attached to an outer periphery of the top ring body 2. The top ring body 2 is made of resin such as an engineering plastic (for example, PEEK). An elastic film (membrane) 4 in contact with a back surface of the substrate is attached to a lower surface of the top ring body 2. In an embodiment, the elastic film (membrane) 4 is formed of a rubber material having excellent strength and durability such as ethylene propylene rubber (EPDM), polyurethane rubber, or silicon rubber. In an embodiment, the elastic film (membrane) 4 can be formed from a rubber material using a mold.

The elastic film (membrane) 4 includes a plurality of concentric partition walls 4a, and these partition walls 4a form, between an upper surface of the elastic film 4 and the lower surface of the top ring body 2, a circular center chamber 5, a quadrangular annular ripple chamber 6 surrounding the center chamber 5, a quadrangular annular intermediate chamber 7 surrounding the ripple chamber 6, a quadrangular annular outer chamber 8 surrounding the intermediate chamber 7, and a quadrangular annular edge chamber 9 surrounding the outer chamber 8. That is, the center chamber 5 is formed in the center of the top ring body 2, and the ripple chamber 6, the intermediate chamber 7, the outer chamber 8, and the edge chamber 9 are formed sequentially and concentrically from the center toward the outer periphery. In the elastic membrane 4, a plurality of vacuum suction holes (not shown) are formed to communicate with the ripple chamber 6 for vacuum-suctioning the substrate WF to the top ring 302. The vacuum suction holes are coupled to a vacuum source (not shown), and the substrate WF can be vacuum suctioned onto the elastic film 4 of the top ring 302 via the vacuum suction holes.

Furthermore, a retainer member pressurizing chamber 10 made of an elastic film is also formed over the retainer member 3. The center chamber 5, the ripple chamber 6, the intermediate chamber 7, the outer chamber 8, the edge chamber 9 and the retainer member pressurizing chamber 10 are connected to a pressure adjuster (not shown) via flow paths 11 to 16. With such a structure, a pressing force to press the substrate WF onto the polishing pad 352 can be adjusted for each region of the substrate WF, and the retainer member 3 can adjust the pressing force to press the polishing pad 352.

### <Drying Unit>

A drying unit is a device for drying the substrate WF. In the substrate polishing apparatus 1000 shown in Fig. 1, the drying unit 500 dries the substrate WF polished by the polishing unit 300 and then cleaned by the cleaner of the conveyer unit 200. As shown in Fig. 1, the drying unit 500 is disposed downstream of the conveyer unit 200.

The drying unit 500 includes nozzles 530 for injecting gas toward the substrate WF to be conveyed on the conveying rollers 202. The gas can be, for example, compressed air or nitrogen. In the shown embodiment, the nozzles 530 may include a lower nozzle configured to jet gas from below the conveying roller 202 to the lower surface of the substrate WF, and an upper nozzle configured to jet gas from above the conveying roller 202 to the upper surface of the substrate WF. One lower nozzle and one upper nozzle may be provided, or a plurality of lower and upper nozzles may be provided in the conveying direction of the substrate WF. Furthermore, in a form of each nozzle 530, the nozzle can be a slit in which a gas supply port extends about the width of the substrate WF.

### <Unload Unit>

The unload unit 600 is a unit for unloading the substrate WF that has been polished, cleaned, or otherwise treated to the outside of the substrate polishing apparatus 1000. In the substrate polishing apparatus 1000 shown in Fig. 1, the unload unit 600 receives the substrate dried in the drying unit 500. As shown in Fig. 1, the unload unit 600 is disposed downstream of the drying unit 500.

### <Substrate Polishing Method>

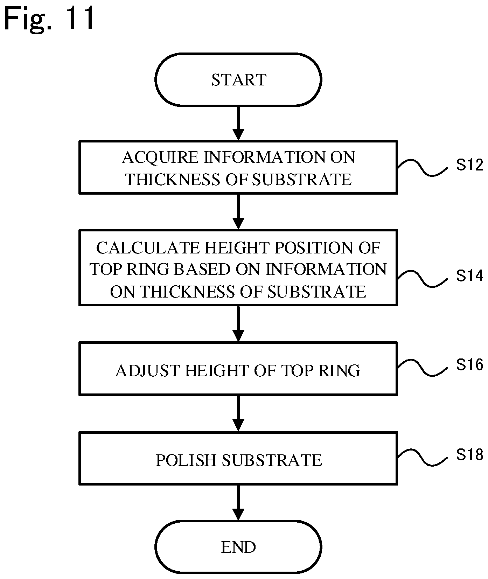

Next, a substrate polishing method by the substrate polishing apparatus 1000 in the present embodiment will be described. Fig. 11 is a flowchart showing the substrate polishing method according to an embodiment. This substrate polishing method is executed primarily by the controller 900 by reading a program stored in the storage device 900a or the like. This substrate polishing method is executed when the substrate WF is input to the load unit 100 as an example.

### <Acquisition Step>

In the substrate polishing method, the controller 900 first acquires information on the thickness of the substrate WF to be polished (step S12). Here, as an example, the information on the thickness of the substrate WF may be the thickness of the substrate WF itself or information indicating the thickness of the substrate WF. Hereinafter, the information on the thickness of the substrate WF may be referred to as "thickness information". As an example, the thickness information of the substrate WF can be acquired using at least one of acquisition steps described below.

### <Acquisition Step 1>

The controller 900 can acquire the thickness information of the substrate WF based on a detection signal input from the sensor 260 provided in the load unit 100 (or the conveyer unit 200) (see Figs. 2 and 3). In this acquisition step, the thickness of the substrate WF on the conveying rollers 202 is acquired. The acquisition of the thickness information of the substrate WF by the sensor 260 may be performed while moving the substrate WF by the conveying rollers 202. Alternatively, the thickness information of the substrate WF by the sensor 260 may be acquired while the conveyance by the conveying rollers 202 is stopped. The sensor 260 may detect a plurality of locations on the substrate WF in the conveying direction by the conveying rollers 202. In this case, the controller 900 may acquire an average value at the plurality of locations on the substrate WF as the thickness information.

### <Acquisition Step 2>

The controller 900 may acquire the thickness information of the substrate WF when the substrate WF is transferred from the pusher 230 to the top ring 302. The controller 900 can acquire the thickness information of the substrate WF based on a distance by which the pusher 230 moves the substrate WF to transfer the substrate WF to the top ring 302, specifically for example, the amount of movement Dh of the second stage 270 relative to the first stage 232 (see Fig. 8). As a specific example, the controller 900 can acquire the thickness information of the substrate WF based on a detection signal input from the sensor 262 provided in the conveyer unit 200 (see Figs. 4 to 8).

### <Acquisition Step 3>

The controller 900 may acquire the thickness information of the substrate WF by bringing the top ring 302 holding the substrate WF to be polished into contact with the polishing table 350. This acquisition step may be performed in conjunction with pad search by the top ring 302 as an example. Here, the pad search is a step of detecting the height (position) of the surface of the polishing pad 352. The pad search by the top ring is performed by detecting the height position of the top ring 302 when the lower surface of the top ring 302 is brought into contact with the surface (polishing surface) of the polishing pad 352, and during the pad search, the servo motor 38 is driven to lower the top ring 302 while accumulating the number of revolutions with an encoder. When the lower surface of the top ring 302 contacts the surface of the polishing pad 352, a load on the servo motor 38 increases, and a current flowing through the servo motor 38 increases. Therefore, when a current detector of the controller 900 detects the current flowing through the servo motor 38 and the current increases, it is determined that the lower surface of the top ring 302 contacts the surface of the polishing pad 352. When it is determined that the lower surface of the top ring 302 contacts the surface of the polishing pad 352, the controller 900 obtains the height of the surface of the polishing pad 352 from an integrated value of the servo motor 38 that is obtained by the encoder. In this pad search, the controller 900 may acquire the thickness information of the substrate WF along with the height of the surface of the polishing pad 352. As an example, the thickness information of the substrate WF may be acquired by detecting the distance between the substrate WF and the polishing pad 352 when the lower surface of the top ring 302 contacts the surface of the polishing pad 352. As another example, the thickness information of the substrate WF may be acquired by bringing the surface of the substrate WF into contact with the polishing pad 352. At this time, an amount of bulge (supply fluid amount) of the partition walls 4a of the elastic film (membrane) 4 may be considered. Furthermore, the controller 900 may acquire the thickness information of the substrate WF based on a difference between a reference (standard) height in a state in which the substrate WF is not held and a detected height in a state in which the substrate WF is held. That is, as an example, the controller 900 brings the top ring 302 into contact with the polishing table 350 in the state in which the substrate WF is not held and acquires the height position of the top ring 302 at that time as the reference height. Next, the controller 900 brings the top ring 302 into contact with the polishing table 350 in the state in which the substrate WF is held and acquires the height position of the top ring 302 at that time as the detected height. Then, the controller 900 can acquire the difference between the acquired reference height and the detected height as the thickness information of the substrate WF. Furthermore, the acquisition of the thickness information of the substrate WF in the acquisition step 3 may be performed based on detection by a sensor provided in the top ring 302. As an example, the top ring 302 may include a sensor 264 provided in the retainer member 3 as a sensor for detecting the distance between the substrate WF and the polishing pad 352, or a sensor for detecting the amount of bulge of the elastic film 4 when the substrate WF contacts the polishing pad 352 (see Fig. 10). The sensor 264 may be any type of sensor, for example, an optical ranging sensor. Furthermore, the sensor 264 may be provided on the polishing table 350. As an example, the sensor 264 is provided in a lower part of the polishing table 350, and apertures, through which sensing light of the sensor 264 can pass, may be formed in the polishing table 350 and the polishing pad 352, respectively. In this case, a window member through which the sensing light can pass may be disposed in the apertures of the polishing table 350 and the polishing pad 352. The window member may be composed of a light transmitting member made of a material having light transmittance, specifically a transparent material (for example, transparent plastic, transparent glass, or the like). Disposing the window member can prevent pure water or polishing liquid from being applied to the sensor 264. In addition, when the top ring 302 or the substrate WF is brought into contact with the polishing pad 352 to acquire the thickness information of the substrate WF, the top ring 302 is preferably brought into contact with the polishing pad 352 in a state in which the top ring 302 and the polishing pad 352 are not rotated.

### <Acquisition Step 4>

When a user recognizes the thickness information of the substrate WF in advance, the thickness information may be stored in the storage device 900a of the controller 900 in response to external input. In this case, the controller 900 can acquire the thickness information of the substrate WF by reading the thickness information of the substrate WF stored in the storage device 900a. As a further example, when a plurality of similar substrates WF are continuously input to the substrate polishing apparatus 1000, thickness information of one or more substrates WF is acquired, and for the subsequent substrate WF, the previously acquired thickness information may be used.

### <Position Adjustment Step>

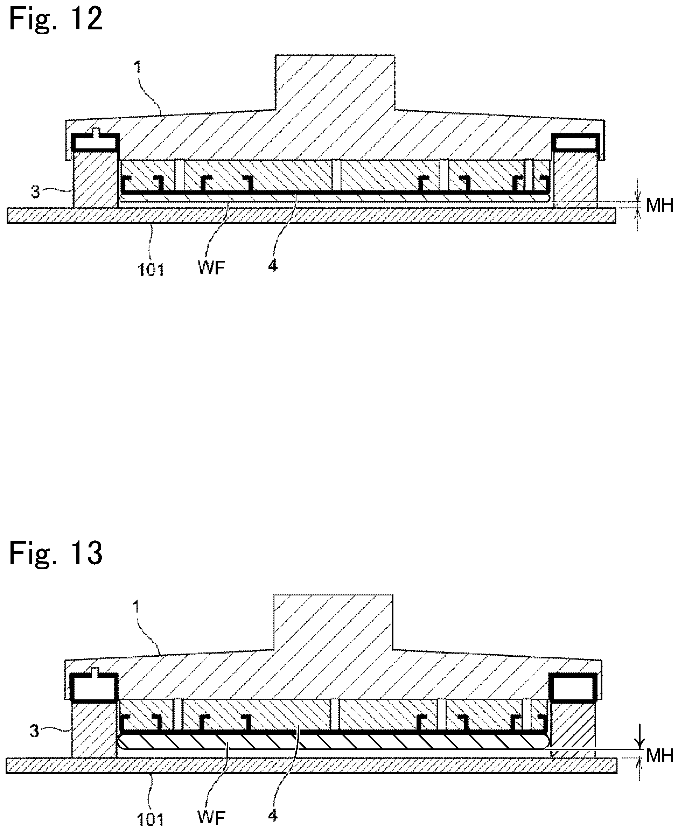

Once the thickness information of the substrate WF is acquired, the controller 900 calculates the height position of the top ring 302 relative to the polishing table 350 based on the acquired thickness information (S14). As a specific example, the controller 900 may calculate an optimal position of the top ring 302 before polished, from the height of the surface of the polishing pad 352. The optimal position of the top ring 302 may be determined so that a membrane height defined as a gap between the top ring body 2 and the elastic film (membrane) 4 is in a predetermined desired range, based on the thickness information of the substrate WF. When the position of the top ring 302 relative to the polishing pad 352 is adjusted without considering the thickness of the substrate WF, a distance between the substrate WF and the polishing pad 352 (membrane height MH) is reduced if the thickness of the substrate WF is large, and the distance between the substrate WF and the polishing pad 352 increases if the thickness of the substrate WF is small. For this reason, in the present embodiment, the controller 900 calculates the height position of the top ring 302 based on the thickness information of the substrate WF. Specifically, the height position of the top ring 302 may be calculated so that the larger the thickness of the substrate WF is, the larger the distance between the top ring body 2 and the polishing pad 352 becomes, and so that the smaller the thickness of the substrate WF is, the smaller the distance between the top ring body 2 and the polishing pad 352 becomes. Fig. 12 is a cross-sectional view showing the top ring and the polishing pad when the thickness of the substrate is relatively small, according to an embodiment, and Fig. 13 is a cross-sectional view showing the top ring and the polishing pad when the thickness of the substrate is relatively large, according to an embodiment. As shown in Figs. 12 and 13, the controller 900 may calculate the height position of the top ring 302 so that the membrane height MH is within a substantially certain range in consideration of the thickness information of the substrate WF.

Referring again to Fig. 11, the controller 900 then adjusts the height position of the top ring 302 relative to the polishing table 350 to obtain the calculated height position of the top ring (step S16). The controller 900 then presses the substrate WF onto the polishing pad 352 to polish the substrate WF, while rotating the polishing table 350 and the top ring 302 with rotation of the top ring 302 and the polishing table 350 (step S18).

The controller 900 may polish the substrate WF with only one of the polishing units 300A and 300B or may polish the same substrate WF in two stages with the polishing units 300A and 300B. In the case of polishing the substrate WF in two stages, in a polishing process of the substrate WF with the polishing unit 300B, the height position of the top ring 302 relative to the polishing table 350 of the polishing unit 300B may be adjusted based on the thickness information of the substrate WF acquired before the polishing of the substrate WF in the polishing unit 300A, and an amount of the substrate WF polished in the polishing unit 300A, or based on the thickness information of the substrate WF acquired in the conveyer unit 200B before the polishing of the substrate WF in the polishing unit 300B. In this way, even during polishing with the polishing unit 300B in the second stage of polishing, the position of the top ring 302 can be adjusted to an appropriate position to perform the processing. For example, a numerical value determined in advance by simulation or the like may be used as a polishing amount in the polishing unit 300A, or the polishing amount may be calculated based on a time required for polishing in the polishing unit 300A, the amount of pressure fluid to the elastic film 4, or the like.

When the polishing of the substrate WF in the polishing unit 300 is ended, the arm 360 is swung to move the top ring 302 holding the substrate WF to the substrate transfer position of the conveyer unit 200. Thereafter, the vacuum suctioning of the top ring 302 is released, and the substrate WF is supported by the support posts 272 of the second stage 270. Thereafter, the pusher 230 is lowered and the substrate WF is transferred onto the conveying rollers 202 (see Fig. 6).

When the polishing unit 300 ends the polishing of the substrate WF, the polishing unit 300 performs dressing, cleaning, and the like of the polishing pad 352 using the dressing unit 356, an atomizer 358, and the like. At this time, the amount of wear on the polishing pad 352 may be measured using the dresser 50 as described above. Furthermore, the controller 900 may compensate for the wear on the polishing pad 352 when adjusting the height position of the top ring 302 for a continuously new substrate polishing process (Fig. 11: S14, S16). As an example, the controller 900 may calculate the height position of the top ring 302 for the continuously new substrate WF polishing process so that the height position is lower by a distance corresponding to the previously measured amount of wear on the polishing pad 352. In the polishing unit 300, the polishing pad 352 may be dressed and cleaned each time a polishing process of one substrate WF is performed, or the polishing pad 352 may be dressed and cleaned each time a polishing process of a plurality of substrates WF is performed. Furthermore, the controller 900 may estimate the amount of wear on the polishing pad 352 during the polishing process of one substrate WF or estimate a current amount of wear on the polishing pad 352 based on the amount of wear on the polishing pad 352 that is measured using the dresser 50 or based on the amount of wear on the polishing pad 352 determined in advance by a polishing recipe. As an example, the controller 900 may estimate the amount of wear on the polishing pad 352 during the polishing process of one substrate WF by accumulating and averaging past data. The controller 900 may then correct the height position based on the estimated amount of wear on the polishing pad 352, in adjusting the height position of the top ring 302 (Fig. 11: S14, S16).

When the substrate WF is transferred from the polishing unit 300 to the conveyer unit 200, the conveying rollers 202 are started again to convey the substrate WF. When cleaning the substrate WF, the rotation speed of the conveying roller 202 may be changed to a speed for cleaning. While conveying the substrate WF with the conveying rollers 202, the cleaning solution is injected from the upper cleaning nozzle 284a and the lower cleaning nozzle 284b toward the substrate WF to clean the substrate WF.

Then, the substrate WF is conveyed from the conveyer unit 200 to the drying unit 500, dried, and then conveyed to the unload unit 600. The substrate WF conveyed to the unload unit 600 is conveyed to the outlet by the conveying rollers 202 and conveyed to the outside of the substrate polishing apparatus 1000.

In a substrate processing method described above, the thickness information of the substrate WF is acquired, and the position of the top ring 302 relative to the polishing table 350 is adjusted based on the acquired thickness information of the substrate WF, to polish the substrate WF. As a result, an appropriate polishing process can be performed in correspondence with the substrates WF having various dimensions.

The substrate processing method described above is preferably performed without discharging the substrate WF from the unload unit 600, that is, without discharging the substrate from a processing line including the conveyer unit 200. In this way, a time required for the substrate polishing process can be reduced.

The present invention can be also described in forms as follows.

### [Form 1]

According to Form 1, a substrate polishing method by a polishing apparatus is provided, the polishing apparatus including a polishing table having a polishing surface, a top ring for holding a substrate to press the substrate onto the polishing surface, an upward/downward moving mechanism that moves the top ring up and down, and a sensor for acquiring information on a thickness of the substrate. The top ring includes a membrane that is an elastic film and that forms a pressure chamber to which a pressure fluid is supplied, and a top ring body that holds the membrane, and is configured to press the substrate onto the polishing surface by the pressure fluid being supplied to the pressure chamber. The substrate polishing method includes an acquisition step of acquiring the information on the thickness of the substrate by the sensor, a position adjustment step of adjusting a height position of the top ring relative to the polishing table based on the acquired information on the thickness of the substrate, and a polishing step of supplying the pressure fluid to the pressure chamber and pressing the substrate onto the polishing surface, to polish the substrate.

According to Form 1, the height position of the top ring relative to the polishing table can be adjusted based on the thickness of the substrate, so that polishing can be performed in correspondence with substrates having various dimensions.

### [Form 2]

According to Form 2, in Form 1, the acquisition step is performed by bringing the top ring holding the substrate into contact with the polishing table.

### [Form 3]

According to Form 3, in Form 2, the polishing apparatus includes a polishing table rotation mechanism for rotating the polishing table, and the acquisition step is performed in a state in which the polishing table is not rotated.

### [Form 4]

According to Form 4, in Form 1, the polishing apparatus includes a pusher that transfers the substrate to and from the top ring, and the acquisition step is performed when the substrate is transferred from the pusher to the top ring.

### [Form 5]

According to Form 5, in Form 4, the acquisition step includes acquiring the information on the thickness of the substrate based on a distance by which the pusher moves the substrate to transfer the substrate to the top ring.

### [Form 6]

According to Form 6, in Form 1, the polishing apparatus includes a conveyer unit for conveying the substrate, and the acquisition step includes acquiring the information on the thickness of the substrate by a sensor provided in the conveyer unit.

### [Form 7]

According to Form 7, in Forms 1 to 6, the polishing apparatus includes a processing line including a conveyer unit for conveying the substrate, and the acquisition step, the position adjustment step, and the polishing step are performed without unloading the substrate out of the processing line.

### [Form 8]

According to Form 8, in Form 1, the acquisition step is performed in response to external input to the polishing apparatus.

### [Form 9]

According to Form 9, in Forms 1 to 6, the method includes: after the polishing step, a second position adjustment step of adjusting a height position of a second top ring relative to a second polishing table, based on the information on the thickness of the substrate that is acquired in the acquisition step, and an amount of the substrate polished by the polishing step, and a second polishing step of pressing the substrate onto a polishing surface of the second polishing table to polish the substrate.

### [Form 10]

According to Form 10, a program for causing a processing device of a polishing apparatus to perform a control process of performing a polishing process on a processing surface of a substrate is provided. The polishing apparatus includes a polishing table having a polishing surface, a top ring for holding the substrate to press the substrate onto the polishing surface, an upward/downward moving mechanism that moves the top ring up and down, and a sensor for acquiring information on a thickness of the substrate, the top ring including a membrane that is an elastic film and that forms a pressure chamber to which a pressure fluid is supplied, and a top ring body that holds the membrane, the top ring being configured to press the substrate onto the polishing surface by the pressure fluid being supplied to the pressure chamber. The control process includes an acquisition step of acquiring the information on the thickness of the substrate by the sensor, a position adjustment step of adjusting a height position of the top ring relative to the polishing table based on the acquired information on the thickness of the substrate, and a polishing step of supplying the pressure fluid to the pressure chamber and pressing the substrate onto the polishing surface, to polish the substrate.

According to Form 10, the height position of the top ring relative to the polishing table is adjusted based on the thickness of the substrate, so that polishing can be performed in correspondence with substrates having various dimensions.

### [Form 11]

According to Form 11, a substrate polishing apparatus is provided, the substrate polishing apparatus including: a polishing table having a polishing surface; a top ring for holding a substrate to press the substrate onto the polishing surface, the top ring including a membrane that is an elastic film and that forms a pressure chamber to which a pressure fluid is supplied, and a top ring body that holds the membrane, the top ring being configured to press the substrate onto the polishing surface by the pressure fluid being supplied to the pressure chamber; an upward/downward moving mechanism that moves the top ring up and down; a sensor for acquiring information on a thickness of the substrate; and a controller configured to adjust a height position of the top ring relative to the polishing table based on the information on the thickness of the substrate that is acquired by the sensor and supply the pressure fluid to the pressure chamber to press the substrate onto the polishing surface and thereby polish the substrate.

According to Form 11, the height position of the top ring relative to the polishing table is adjusted based on the thickness of the substrate, so that polishing can be performed in correspondence with substrates having various dimensions.

As above, the embodiments of the present invention have been described, and the embodiments of the present invention described above are intended to facilitate understanding of the present invention and do not limit the present invention. The present invention can be changed or improved without departing from the gist of the invention, and the present invention certainly includes its equivalents. Furthermore, to the extent that at least some of the above-described problems can be solved or to the extent that at least some of effects can be achieved, any combination of the embodiments and modifications is possible, and any combination or omission of respective components described in the claims and specification is possible.

The present application is based on and claims the benefit of priority of Japanese Patent Application No. 2022-081873 filed on May 18, 2022. All disclosure contents, including specification, claims, drawings and abstract of Japanese Patent Application No. 2022-081873 are incorporated herein in entirety by reference. All disclosures, including the specifications, claims, drawings, and abstracts of Japanese Patent Laid-Open Nos. 2003-103458 (Patent Literature 1), 2014-176950 (Patent Literature 2), and 2010-46756 (Patent Literature 3) are incorporated in entirety in the present application by reference.

### REFERENCE SIGNS LIST

- 3: retainer member
- 100: load unit
- 200: conveyer unit
- 230: pusher
- 231: first lifting mechanism
- 232: first stage
- 233: second lifting mechanism
- 260: sensor
- 262: sensor
- 264: sensor
- 270: second stage
- 272: support post
- 300: polishing unit
- 302: top ring
- 350: polishing table
- 352: polishing pad
- 500: drying unit
- 600: unload unit
- 900: controller
- 900a: storage device
- 1000: substrate polishing apparatus
- WF: substrate

## Claims

1. A substrate polishing method by a polishing apparatus, the polishing apparatus comprising: a polishing table having a polishing surface; a top ring for holding a substrate to press the substrate onto the polishing surface; an upward/downward moving mechanism that moves the top ring up and down; and a sensor for acquiring information on a thickness of the substrate,
the top ring including a membrane that is an elastic film and that forms a pressure chamber to which a pressure fluid is supplied, and a top ring body that holds the membrane, the top ring being configured to press the substrate onto the polishing surface by the pressure fluid being supplied to the pressure chamber,
the substrate polishing method comprising:
an acquisition step of acquiring the information on the thickness of the substrate by the sensor;
a position adjustment step of adjusting a height position of the top ring relative to the polishing table based on the acquired information on the thickness of the substrate; and
a polishing step of supplying the pressure fluid to the pressure chamber and pressing the substrate onto the polishing surface, to polish the substrate.

2. The substrate polishing method according to claim 1, wherein the acquisition step is performed by bringing the top ring holding the substrate into contact with the polishing table.

3. The substrate polishing method according to claim 2, wherein the polishing apparatus includes a polishing table rotation mechanism for rotating the polishing table, and
the acquisition step is performed in a state in which the polishing table is not rotated.

4. The substrate polishing method according to claim 1, wherein the polishing apparatus includes a pusher that transfers the substrate to and from the top ring, and
the acquisition step is performed when the substrate is transferred from the pusher to the top ring.

5. The substrate polishing method according to claim 4, wherein the acquisition step includes acquiring the information on the thickness of the substrate based on a distance by which the pusher moves the substrate to transfer the substrate to the top ring.

6. The substrate polishing method according to claim 1, wherein the polishing apparatus includes a load unit or a conveyer unit configured to convey the substrate, and
the acquisition step includes acquiring the information on the thickness of the substrate by a sensor provided in the load unit or the conveyer unit.

7. The substrate polishing method according to any one of claims 1 to 6, wherein the polishing apparatus includes a processing line including a conveyer unit for conveying the substrate, and
the acquisition step, the position adjustment step, and the polishing step are performed without unloading the substrate out of the processing line.

8. The substrate polishing method according to claim 1, wherein the acquisition step is performed in response to external input to the polishing apparatus.

9. The substrate polishing method according to any one of claims 1 to 6, including:
after the polishing step,
a second position adjustment step of adjusting a height position of a second top ring relative to a second polishing table, based on the information on the thickness of the substrate that is acquired in the acquisition step, and an amount of the substrate polished by the polishing step; and
a second polishing step of pressing the substrate onto a polishing surface of the second polishing table to polish the substrate.

10. A program for causing a processing device of a polishing apparatus to perform a control process of performing a polishing process on a processing surface of a substrate, the polishing apparatus comprising: a polishing table having a polishing surface; a top ring for holding the substrate to press the substrate onto the polishing surface; an upward/downward moving mechanism that moves the top ring up and down; and a sensor for acquiring information on a thickness of the substrate,
the top ring including: a membrane that is an elastic film and that forms a pressure chamber to which a pressure fluid is supplied; and a top ring body that holds the membrane, the top ring being configured to press the substrate onto the polishing surface by the pressure fluid being supplied to the pressure chamber,
the control process including:
an acquisition step of acquiring the information on the thickness of the substrate by the sensor;
a position adjustment step of adjusting a height position of the top ring relative to the polishing table based on the acquired information on the thickness of the substrate; and
a polishing step of supplying the pressure fluid to the pressure chamber and pressing the substrate onto the polishing surface, to polish the substrate.

11. A substrate polishing apparatus comprising:
a polishing table having a polishing surface;
a top ring for holding a substrate to press the substrate onto the polishing surface, the top ring including a membrane that is an elastic film and that forms a pressure chamber to which a pressure fluid is supplied, and a top ring body that holds the membrane, the top ring being configured to press the substrate onto the polishing surface by the pressure fluid being supplied to the pressure chamber;
an upward/downward moving mechanism that moves the top ring up and down;
a sensor for acquiring information on a thickness of the substrate; and
a controller configured to adjust a height position of the top ring relative to the polishing table based on the information on the thickness of the substrate that is acquired by the sensor and supply the pressure fluid to the pressure chamber to press the substrate onto the polishing surface and thereby polish the substrate.
